# EUROPEAN PATENT APPLICATION

(11) **EP 4 412 017 A1**
(43) Date of publication of application: **07.08.2024**
(21) Application number: 24150885.2
(22) Date of filing: 09.01.2024
(51) Int. Cl.: H02H 3/087, H02H 3/07, H02H 3/08, H02H 7/18, H02H 3/093

(54) **SWITCH CONTROL DEVICE AND BATTERY PACK INCLUDING THE SAME**

(30) Priority: 27.01.2023 KR 20230011180
(71) Applicant: Samsung SDI Co., Ltd., Yongin-si, Gyeonggi-do 17084 (KR)
(72) Inventor: CHO, Kyusung, 17084 Yongin-si (KR)
(74) Representative: Marks & Clerk LLP

(57) **Abstract**

A switch control device including: an overcurrent detection circuit (110) configured to output an overcurrent detection signal if an overcurrent is detected in a current path in which a switch is disposed; a counter circuit (120) configured to output a latch control signal whose voltage is varied in response to a number of outputs of the overcurrent detection signal; a latch circuit (130) configured to continuously output a latch signal if the voltage of the latch control signal is higher than a predetermined voltage; and an off circuit (140) configured to output an off signal controlling the switch to be turned off if the overcurrent detection signal is outputted from the overcurrent detection circuit or the latch signal is outputted from the latch circuit.

## Description

### BACKGROUND

### 1. Field

The present disclosure relates to a switch control device and a battery pack including the same.

### 2. Description of the Related Art

Recently, as environmental regulations such as CO₂ regulations have been strengthened, interest in environmentally-friendly vehicles is increasing. Accordingly, automobile companies are actively conducting research and product development on pure electric vehicles or hydrogen vehicles as well as hybrid vehicles or plug-in hybrid vehicles.

A high-voltage battery pack is provided for environmentally-friendly vehicles to store electrical energy obtained from various energy sources. A high-voltage electrical system of a vehicle uses high-voltage electrical energy provided from a high-voltage battery as driving or electrical energy for the vehicle.

In the battery pack, an output of the battery pack may be transmitted or blocked to a load by a switch such as a relay or a contactor. In order to protect the battery pack from an overcurrent or short-circuit current, a controller in the battery pack monitors a current value to turn off the switch, or a protection circuit being configured of hardware without a controller monitors the current value to turn off the switch. On the other hand, if an overcurrent or short-circuit current occurs, because the method in which the protection circuit being configured of hardware turns off the switch maintains the switch off even after a temporary overload or short circuit is resolved so that the battery pack may return to normal operation, problems in system operation may occur.

### SUMMARY

Embodiments are directed to a switch control device and a battery pack that includes a switch control device.

The present disclosure has been made in an effort to provide a switch control device and a battery pack including the same that may return to a previous state of a switch if processing a temporary overload or short circuit situation of a battery pack, and may permanently turn off the switch in a continuous overload or short circuit situation.

Embodiments are directed to a switch control device, having an overcurrent detection circuit configured to output an overcurrent detection signal if an overcurrent is detected in a current path in which a switch is disposed, a counter circuit configured to output a latch control signal whose voltage is varied in response to a number of outputs of the overcurrent detection signal, a latch circuit configured to continuously output a latch signal if the voltage of the latch control signal is higher than a predetermined voltage, and an off circuit configured to output an off signal controlling the switch to be turned off if the overcurrent detection signal is outputted from the overcurrent detection circuit or the latch signal is outputted from the latch circuit.

The overcurrent detection circuit may be configured to receive a current detection signal from a current detection device, the current detection signal indicating an amount of current in the current path. The overcurrent detection circuit may be configured to compare a reference voltage to the current detection signal and to output the overcurrent detection signal if the current detection signal exceeds the reference voltage.

The counter circuit may be configured to vary the voltage of the latch control signal by increasing the latch control signal with at least one of: the number of outputs of the overcurrent detection signal and/or the amount of time for which the overcurrent detection signal is output by the overcurrent detection circuit.

The latch control signal may be configured to, in response to the voltage of the latch control signal exceeding the predetermined voltage at a first time, continuously output the latch signal (e.g. the latch signal remains high) following the first time.

The latch control signal may be configured to, between successive ones of the number of outputs of the overcurrent detection signal, reduce the voltage of the latch control signal.

The off circuit may be configured to output the off signal controlling the switch to be turned off if at least one of the following conditions is met: the overcurrent detection signal is outputted from the overcurrent detection circuit and/or the latch signal is outputted from the latch circuit.

In embodiments, the overcurrent detection circuit includes a first comparator having a first input terminal to which a first reference voltage is inputted, a second input terminal to which a current detection signal for the current path is inputted, and an output terminal, and the first comparator outputs the overcurrent detection signal if a voltage of the current detection signal is higher than the first reference voltage.

In embodiments, the overcurrent detection circuit further includes a first voltage divider circuit connected between a power node and the ground and configured to apply the first reference voltage divided from a voltage applied to the power node to a first input terminal of the first comparator. The power node may be a node, terminal or supply rail at which the relevant voltage (VCC) is applied.

In embodiments, the counter circuit includes a first resistor connected between the overcurrent detection circuit and the latch circuit, and a first capacitor connected between the latch circuit and the ground.

In embodiments, if the overcurrent detection signal is not outputted from the overcurrent detection circuit for a predetermined time or longer, the voltage of the latch control signal is reset to an initial value.

In embodiments, the latch circuit includes a second comparator including a first input terminal to which a second reference voltage is inputted, a second input terminal to which the latch control signal is inputted, and an output terminal, and a first diode including an anode connected to the output terminal of the second comparator and a cathode connected to the second input terminal of the second comparator, wherein the first diode is configured to transmit the latch signal to the second input terminal of the second comparator if the latch signal is output from the second comparator and a voltage of the latch signal transmitted to the second input terminal of the second comparator by the first diode is higher than the second reference voltage.

In embodiments, the latch circuit further includes a second voltage divider circuit connected between a power node and the ground and applying the second reference voltage divided from a voltage applied to the power node to a first input terminal of the second comparator. The power node may be a node, terminal or supply rail at which the relevant voltage is applied.

In embodiments, the latch circuit further includes a second diode including an anode connected to the output terminal of the second comparator and a cathode connected to the off circuit.

In embodiments, the off circuit includes a transistor including a first terminal connected to a switch driver that controls the switch, a second terminal connected to the ground, and a control terminal, and the transistor is turned on if the overcurrent detection signal or the latch signal is inputted to the control terminal, and if turned on, the switch driver and the ground are connected to output the off signal corresponding to a ground voltage to the switch driver.

In embodiments, the off circuit further includes a delay circuit that receives the overcurrent detection signal or the latch signal and delays the received overcurrent detection signal or latch signal to transmit the delayed signal to the control terminal of the transistor.

In embodiments, the delay circuit further includes a second resistor connected between a node connected to the overcurrent detection circuit and the latch circuit to receive the overcurrent detection signal or the latch signal and the control terminal of the transistor, and a second capacitor connected between the control terminal of the transistor and the ground.

The control terminal may be a gate or a base of the transistor.

Embodiments are directed to a battery pack, including a battery module, a switch in a current path between the battery module and a load, a switch driver controlling an on/off status of the switch, and a switch control device having an overcurrent detection circuit configured to output an overcurrent detection signal if an overcurrent is detected in a current path in which a switch is disposed, a counter circuit configured to output a latch control signal whose voltage is varied in response to a number of outputs of the overcurrent detection signal, a latch circuit configured to continuously output a latch signal if the voltage of the latch control signal is higher than a predetermined voltage, and an off circuit configured to output an off signal controlling the switch to be turned off if the overcurrent detection signal is outputted from the overcurrent detection circuit or the latch signal is outputted from the latch circuit, wherein the switch control device, if an overcurrent is detected in the current path, outputs the off signal turning off the switch to the switch driver. The battery pack may include a current detection device, which is configured to output a current detection signal to the overcurrent detection circuit, the current detection signal indicating an amount of current in the current path. The overcurrent detection circuit may be configured to compare the current detection signal to a reference voltage and to output the overcurrent detection signal if the current detection signal exceeds the reference voltage. In embodiments, the battery pack further includes a controller controlling the switch driver independently of the switch control device.

Embodiments are directed to a battery pack, having a battery module, a switch in a current path between the battery module and a load, a switch driver controlling an on/off status of the switch, and a switch control device, having an overcurrent detection circuit configured to output an overcurrent detection signal if an overcurrent is detected in a current path in which a switch is disposed, a counter circuit configured to output a latch control signal whose voltage is varied in response to a number of outputs of the overcurrent detection signal, a latch circuit configured to continuously output a latch signal if the voltage of the latch control signal is higher than a predetermined voltage, and an off circuit configured to output an off signal controlling the switch to be turned off if the overcurrent detection signal is outputted from the overcurrent detection circuit or the latch signal is outputted from the latch circuit, wherein the overcurrent detection circuit includes a first comparator having a first input terminal to which a first reference voltage is inputted, a second input terminal to which a current detection signal for the current path is inputted, and an output terminal, and the first comparator outputs the overcurrent detection signal if a voltage of the current detection signal is higher than the first reference voltage, and the switch control device, if an overcurrent is detected in the current path, outputs the off signal turning off the switch to the switch driver.

In embodiments, the battery pack further includes a controller controlling the switch driver independently of the switch control device.

Embodiments are also directed to a battery pack, having a battery module, a switch disposed in a current path between the battery module and a load, a switch driver controlling an on/off status of the switch, and a switch control device having an overcurrent detection circuit configured to output an overcurrent detection signal if an overcurrent is detected in a current path in which a switch is disposed, a counter circuit configured to output a latch control signal whose voltage is varied in response to a number of outputs of the overcurrent detection signal, a latch circuit configured to continuously output a latch signal if the voltage of the latch control signal is higher than a predetermined voltage, and an off circuit configured to output an off signal controlling the switch to be turned off if the overcurrent detection signal is outputted from the overcurrent detection circuit or the latch signal is outputted from the latch circuit, wherein the overcurrent detection circuit includes a first comparator having a first input terminal to which a first reference voltage is inputted, a second input terminal to which a current detection signal for the current path is inputted, and an output terminal, the first comparator outputs the overcurrent detection signal if a voltage of the current detection signal is higher than the first reference voltage, the overcurrent detection circuit further includes a first voltage divider circuit connected between a power node and the ground and configured to apply the first reference voltage divided from a voltage applied to the power node to a first input terminal of the first comparator, the counter circuit includes a first resistor connected between the overcurrent detection circuit and the latch circuit, and a first capacitor connected between the latch circuit and the ground, and the switch control device, if an overcurrent is detected in the current path, outputs the off signal turning off the switch to the switch driver.

In embodiments, the battery pack further includes a controller controlling the switch driver independently of the switch control device.

Embodiments are directed to a battery pack, having a battery module,
a switch disposed in a current path between the battery module and a load, a switch driver controlling an on/off status of the switch, and a switch control device, wherein the switch control device, if an overcurrent is detected in the current path, outputs the off signal turning off the switch to the switch driver.

According to the present disclosure, it is possible to return to a previous state of a switch if processing a temporary overload or short circuit situation of a battery pack, and it is possible to permanently turn off the switch in a continuous overload or short circuit situation.

At least some of the above and other features of the invention are set out in the claims.

### BRIEF DESCRIPTION OF THE DRAWINGS

Features will become apparent to those of skill in the art by describing in detail example embodiments with reference to the attached drawings, in which:
FIG. 1 is a block diagram showing a switch control device according to an embodiment;
FIG. 2 is a circuit diagram showing a configuration of a switch control device according to an embodiment;
FIG. 3 is a timing diagram showing an operation of a switch control device according to an embodiment; and
FIG. 4 is a block diagram showing a battery pack including a switch control device according to an embodiment.

### DETAILED DESCRIPTION

Embodiments of the present disclosure will now be described in detail with accompanying drawings. Effects and characteristics of embodiments, and a realization method thereof will now be described in detail with accompanying drawings. In the drawings, the same reference numerals indicate the same components, and no repeated descriptions thereof will be provided. As those skilled in the art would realize, the described embodiments may be modified in various different ways, all without departing from the scope of the present disclosure. The embodiments are provided as examples so that the present disclosure may be thorough and complete, and will sufficiently supply aspects and characteristics of the present disclosure to a person skilled in the art.

Hence, for the purpose of complete understanding on the aspects and the characteristics of the present disclosure, processes, factors, and skills that may not be needed by a person of ordinary skill in the art may not be described.

In the present specification, the term "and/or" includes all or random combinations of a plurality of items that are related and arranged. In the embodiments of the present disclosure as described, the use of "can" or "may" signifies one or more embodiments of the present disclosure. In the present specification, a singular term may include a plural form unless stated in another way.

In the present specification, terms including ordinal numbers such as "first" and "second" are used to describe various components, but these components are not limited by these terms. The terms are only used to differentiate one component from other components. For example, without departing from the scope rights described in this document, a first component may be referred to as a second component, and similarly, the second component may also be renamed as the first component.

It will be understood that if a component is referred to as being "on" or "connected to" another component, it can be directly on or connected to the other component, or one or more intervening components. In addition, it will also be understood that if a component is referred to as being "between" two components, it can be the only component between the two components, or one or more intervening components may also be present.

Electrically connecting two components includes directly connecting two components, and connecting the same with another component therebetween. The other component may include a switch, a resistor, and/or a capacitor. In the embodiments as described, an expression of connection signifies electrical connection if an expression of direct connection is not provided.

Hereinafter, a switch control device and a battery pack including the same according to embodiments will be described in detail with reference to the drawings.

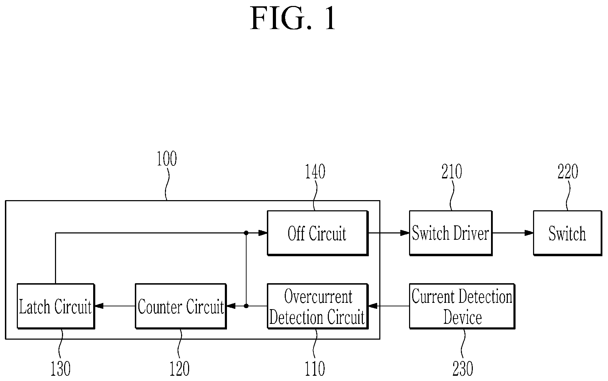

Referring to FIG. 1, a switch control device 100 may receive a current detection signal from a current detection device 230 and may control a switch driver 210 based on the received current detection signal to control an on/off status of a switch 220. The switch control device 100 may include an overcurrent detection circuit 110, a counter circuit 120, a latch circuit 130, and an off circuit 140.

The overcurrent detection circuit 110 may receive a current detection signal from the current detection device 230. The overcurrent detection circuit 110 may detect occurrence of an overcurrent in a current path by using the received current detection signal and may output the overcurrent detection signal if the occurrence of the overcurrent is detected.

The counter circuit 120 may receive an overcurrent detection signal from the overcurrent detection circuit 110 and output a latch control signal in response thereto. A voltage of the latch control signal outputted from the counter circuit 120 may increase in response to the number of times the overcurrent detection signal is received and decrease in response to time if the overcurrent detection signal is not received. That is, the voltage of the latch control signal may gradually increase whenever the overcurrent detection signal is received and may gradually decrease while the overcurrent detection signal is not received. If the overcurrent detection signal is not received for a predetermined period of time or more, the voltage of the latch control signal may be reset to an initial value (for example, 0 V).

The latch circuit 130 may receive the latch control signal from the counter circuit 120. The latch circuit 130 may output a latch signal if a voltage of the latch control signal is greater than or equal to a predetermined reference voltage. If the output of the latch signal is started, the latch circuit 130 may continuously output the latch signal regardless of the value of the latch control signal thereafter.

The off circuit 140 may receive an overcurrent detection signal from the overcurrent detection circuit 110. The off circuit 140 may also receive a latch signal from the latch circuit 130. If an overcurrent detection signal or a latch signal is received, the off circuit 140 may output an off signal to the switch driver 210 to set the switch 220 into an off state.

If an off signal is received from the off circuit 140, the switch driver 210 may control the switch 220 (for example, a contactor, a relay, a transistor, or the like) into an off state. If there is no separate controller (not shown) for controlling the switch driver 210, the switch driver 210 may control the switch 220 to be in an on state if the output of an off signal from the off circuit 140 is blocked.

In the above-described switch control device 100, if an overcurrent detection signal is outputted from the overcurrent detection circuit 110, the switch 220 is turned off by the switch driver 210, and thus the current flowing through the current path may be blocked. If the current is blocked, the overcurrent detection circuit 110 may stop outputting the overcurrent detection signal. If the output of the overcurrent detection signal is stopped, the switch 220 is turned on again by the switch driver 210, and thus a current may flow back into the current path. Accordingly, if an overcurrent temporarily occurs, the switch control device 100 may restore the switch 220 to an on state.

On the other hand, if the current flows again in the current path in a state in which the overcurrent situation is not processed, the overcurrent detection circuit 110 may output an overcurrent detection signal again, and the switch driver 210 may control the switch 220 to be turned off again. As described above, the overcurrent detection circuit 110 repeatedly outputs an overcurrent detection signal in the form of a pulse if the overcurrent situation continues. Therefore, if the overcurrent situation continues, the voltage of the latch control signal outputted from the counter circuit 120 gradually increases, and if the output of the overcurrent detection signal is repeated more than a predetermined number of times, the latch function of the latch circuit 130 may operate based on the latch control signal. If the latch function of the latch circuit 130 operates, the latch signal is continuously outputted from the latch circuit 130, and thus the off circuit 140 may continuously output the off signal. Accordingly, the switch driver 210 may continuously turn off the switch 220 by maintaining the off state of the switch 220.

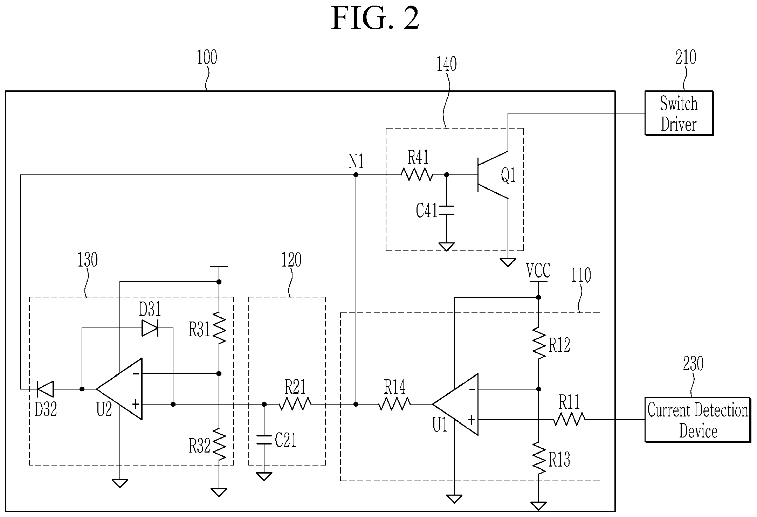

FIG. 2 illustrates an example of a circuit configuration of the switch control device 100 according to the embodiment.

Referring to FIG. 2, the overcurrent detection circuit 110 may include a voltage divider circuit (R12, R13) and a comparator U1.

The resistors R12 and R13 configuring the voltage divider circuit may be connected between a power node VCC and the ground. The resistor R12 may be connected between the power node VCC and a first input terminal of the comparator U1. The resistor R13 may be connected between the first input terminal of the comparator U1 and the ground. Accordingly, the resistors R12 and R13 may transmit a voltage (hereinafter referred to as a 'first reference voltage') divided from a voltage (for example, 5 V) applied to the power node VCC to the first input terminal of the comparator U1.

The comparator U1 may include the first input terminal to which the first reference voltage is inputted from the voltage divider circuit (R12, R13), a second input terminal (for example, a second input terminal) to which the current detection signal from the current detection device 230 is inputted, and an output terminal connected to the counter circuit 120 and the off circuit 140. The comparator U1 may detect the occurrence of an overcurrent in a current path by comparing the voltage of the current detection signal and the first reference voltage. The comparator U1 may output a high-level signal (i.e., an overcurrent detection signal) through the output terminal if the voltage of the current detection signal is higher than the first reference voltage. In addition, if the voltage of the current detection signal is less than or equal to the first reference voltage, the comparator U1 may stop outputting the overcurrent detection signal and maintain a low-level output. In the present document, the high level and the low level may represent a voltage level higher than the corresponding voltage and a voltage level lower than the corresponding voltage, respectively, based on a predetermined voltage. For example, the high level may represent an operation voltage (for example, 5 V) of the comparator U1 or a voltage close to the operation voltage, and the low level may represent a ground voltage (0 V) or a voltage close to the ground voltage.

The overcurrent detection circuit 110 may further include a resistor R1 1 connected between the second input terminal of the comparator U1 and the current detection device 230 and a resistor R14 connected between the output terminal of the comparator U1 and the counter circuit 120, for stable operation.

The counter circuit 120 may include a resistor R21 connected between the output terminal of the comparator U1 of the overcurrent detection circuit 110 and the latch circuit 130 and an RC circuit including a capacitor C21 connected between the latch circuit 130 and the ground. The RC circuit (R21, C21) may output to the latch circuit 130 a signal (latch control signal) whose voltage increases in response to the overcurrent detection signal received from the overcurrent detection circuit 110. The voltage of the latch control signal outputted to the latch circuit 130 by the RC circuit (R21, C21) may increase in proportion to the number of times the overcurrent detection signal is outputted from the comparator U1. A speed at which the voltage of the latch control signal increases in response to the overcurrent detection signal may be determined according to the time constant of the RC circuit (R21, C21). The voltage of the latch control signal may also decrease corresponding to the time if the overcurrent detection signal is not outputted from the comparator U1. Accordingly, the voltage of the latch control signal may gradually decrease while the overcurrent detection signal is not outputted from the comparator U1, and may be reset to an initial value (for example, 0 V) if the overcurrent detection signal is not outputted for a predetermined time or longer.

The latch circuit 130 may include a voltage divider circuit (R31, R32), a comparator U2, and a diode D31.

The resistors R31 and R32 configuring the voltage divider circuit may be connected between a power node VCC and the ground. The resistor R31 may be connected between the power node VCC and a first input terminal (for example, a negative input terminal) of the comparator U2. The resistor R32 may be connected between the first input terminal of the comparator U2 and the ground. Accordingly, the resistors R31 and R32 may transmit a voltage (hereinafter referred to as a 'second reference voltage') divided from a voltage (for example, 5 V) applied to the power node VCC to the first input terminal of the comparator U2.

The comparator U2 may include the first input terminal to which the second reference voltage is inputted from the voltage divider circuit (R31, R32), a second input terminal (for example, a positive input terminal) to which the latch control signal is inputted from the counter circuit 120, and an output terminal connected to the off circuit 140. The comparator U2 may compare the voltage of the latch control signal with the second reference voltage, and may output a high-level signal (latch signal) if the voltage of the latch control signal is higher than the second reference voltage. In addition, if the voltage of the latch control signal is less than or equal to the second reference voltage, the comparator U2 may stop outputting the latch signal and maintain a low-level output.

The diode D31 may include an anode connected to the output terminal of the comparator U2 and a cathode connected to the second input terminal of the comparator U2. If a high-level latch signal is outputted from the comparator U2, the diode D31 may transmit it to the second input terminal of the comparator U2. The voltage transmitted to the second input terminal of the comparator U2 by the diode D31 may be higher than the second reference voltage. Therefore, the comparator U2 may maintain the output of the latch signal regardless of the voltage of the latch control signal.

The latch circuit 130 may further include a diode D32 between the output terminal of the comparator U2 and the off circuit 140. The diode D32 may include an anode connected to the output terminal of the comparator U2 and a cathode connected to the off circuit 140. The diode D32 may block the output signal of the comparator U2 from being transmitted to the off circuit 140 if the low-level signal is outputted from the comparator U2, and may transmit the output signal of the comparator U2 to the off circuit 140 if the high-level latch signal is outputted from the comparator U2. The diode D32 may prevent the off circuit 140 from operating due to the low-level output of the comparator U2 while the overcurrent detection signal is outputted from the overcurrent detection circuit 110.

The off circuit 140 may include a transistor Q1 and an RC circuit (R41, C41).

The transistor Q1 may include a first terminal connected to the switch driver 210, a second terminal connected to the ground, and a control terminal. The control terminal of the transistor Q1 may be connected to the overcurrent detection circuit 110 and the latch circuit 130. The transistor Q1 may be turned on if an overcurrent detection signal is received from the overcurrent detection circuit 110 or a latch signal is received from the latch circuit 130. The transistor Q1 may be turned off if neither the overcurrent detection signal nor the latch signal is received from the overcurrent detection circuit 110 and the latch circuit 130. If the transistor Q1 is turned on, the input terminal of the switch driver 210 and the ground are connected to each other by the transistor Q1, so that an off signal of a low level (ground voltage) may be outputted to the input terminal of the switch driver 210. If the transistor Q 1 is turned off, the connection between the input terminal of the switch driver 210 and the ground is blocked by the transistor Q1, so that the output of the off signal may be blocked.

The transistor Q1 may be, for example, an NPN transistor in which a control terminal is a base terminal, and a first terminal and a second terminal are a collector terminal and an emitter terminal, respectively. In this case, the transistor Q1 may be in a turn-on state if a high-level signal is inputted, and may be in a turn-off state if a low-level signal is inputted.

The resistor R41 may be connected between a node N1 and the control terminal of the transistor Q1, and the capacitor C41 may be connected between the control terminal of the transistor Q1 and the ground. The node N1 may be connected to the overcurrent detection circuit 110 and the latch circuit 130 to receive an overcurrent detection signal outputted from the overcurrent detection circuit 110 or a latch signal outputted from the latch circuit 130. The RC circuit (R41, C41) may operate as a delay circuit that delays the overcurrent detection signal or latch signal applied to the node N1 to transmit it to the control terminal of the transistor Q1. This delay circuit ensures that the transistor Q1 is turned on or off at a predetermined delay time, and accordingly, the switch 220 may also be turned on/off at a predetermined delay time. Accordingly, it is possible to protect the switch 220 from damage caused by heat.

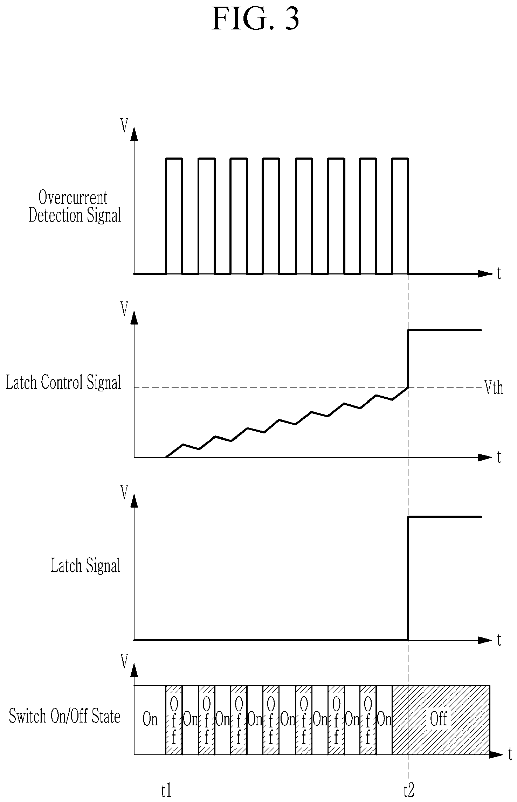

FIG. 3 schematically illustrates an operation timing diagram of the switch control device 100 according to the embodiment.

Referring to FIG. 3, if an overcurrent occurs at a time point tl, the overcurrent detection circuit 110 may output a high-level overcurrent detection signal, and the switch 220 may be turned off. Thereafter, as the overcurrent situation continues, as described above, the overcurrent detection circuit 110 may repeatedly output the overcurrent detection signal in the form of a pulse, and accordingly, the switch 220 may be repeatedly turned on/off.

As the output of the overcurrent detection signal is repeated, the voltage of the latch control signal outputted from the counter circuit 120 may gradually increase. If the overcurrent detection signal is repeatedly outputted more than a predetermined number of times, the voltage of the latch control signal becomes higher than the second reference voltage of the latch circuit 130 (at a time point t2), and thus the latch circuit 130 may maintain the output of the latch signal at a high level. In addition, as the output of the latch signal is maintained, the switch 220 may continuously maintain an off state.

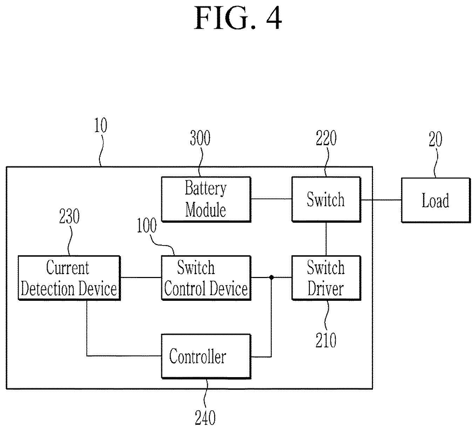

FIG. 4 schematically illustrates a battery pack 10 including the switch control device according to the embodiment.

Referring to FIG. 4, a battery pack 10 may include the switch control device 100, the switch driver 210, the switch 220, the current detection device 230, a controller 240, and a battery module 300.

The battery module 300 may include one or more cells connected in series or parallel to each other.

The switch 220 may be in a current path connecting the battery module 300 and a load 20. The switch 220 may block current flow between the battery module 300 and the load 20 in an off state (that is, an open state), and may allow current flow between the battery module 300 and the load 20 in an on state (that is, a closed state). The on/off of the switch 220 may be controlled by the switch driver 210.

The current detection device 230 may detect a current from the current path between the battery module 300 and the load 20 by using a shunt resistor (not shown), and may output a current detection signal in response to the detected current.

The switch control device 100 may control the on/off state of the switch 220 by controlling the switch driver 210 based on the current detection signal outputted from the current detection device 230. As described with reference to FIG. 1 and FIG. 2, the switch control device 100 may include the overcurrent detection circuit 110, the counter circuit 120, the latch circuit 130, and the off circuit 140.

The controller 240 may manage and control an overall operation of the battery pack 10. For example, the controller 240 may determine an on/off status of the switch 220 based on state information of the battery module 300, state information of a system (for example, a vehicle) in which the battery pack 10 is mounted, and a driving mode, and may output a control signal for controlling the switch 220 to the switch driver 210. The controller 240 may control the on/off status of the switch 220 independently of the switch control device 100.

The controller 240 may be a battery management system (BMS) of the battery pack 10.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims. Therefore, those skilled in the art will understand that various modifications and other equivalent embodiments of the present disclosure are possible. Consequently, the true technical protective scope of the present disclosure must be determined based on the appended claims.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A switch control device, comprising:
an overcurrent detection circuit configured to output an overcurrent detection signal if an overcurrent is detected in a current path in which a switch is disposed;
a counter circuit configured to output a latch control signal whose voltage is varied in response to a number of outputs of the overcurrent detection signal;
a latch circuit configured to continuously output a latch signal if the voltage of the latch control signal is higher than a predetermined voltage; and
an off circuit configured to output an off signal controlling the switch to be turned off if the overcurrent detection signal is outputted from the overcurrent detection circuit or the latch signal is outputted from the latch circuit.

2. The switch control device as claimed in claim 1, wherein:
the overcurrent detection circuit includes a first comparator having a first input terminal to which a first reference voltage is inputted, a second input terminal to which a current detection signal for the current path is inputted, and an output terminal; and
the first comparator is configured to output the overcurrent detection signal if a voltage of the current detection signal is higher than the first reference voltage.

3. The switch control device as claimed in claim 2, wherein the overcurrent detection circuit further includes a first voltage divider circuit connected between a power node and a ground and configured to apply the first reference voltage divided from a voltage applied to the power node to the first input terminal of the first comparator.

4. The switch control device as claimed in any preceding claim, wherein the counter circuit includes a first resistor connected between the overcurrent detection circuit and the latch circuit, and a first capacitor connected between the latch circuit and the ground.

5. The switch control device as claimed in claim 4, wherein the counter circuit is configured to, if the overcurrent detection signal is not outputted from the overcurrent detection circuit for a predetermined time or longer, reset the voltage of the latch control signal to an initial value.

6. The switch control device as claimed in any preceding claim, wherein the latch circuit includes:
a second comparator including a first input terminal to which a second reference voltage is inputted, a second input terminal to which the latch control signal is inputted, and an output terminal; and
a first diode including an anode connected to the output terminal of the second comparator and a cathode connected to the second input terminal of the second comparator,
the first diode configured to transmit the latch signal to the second input terminal of the second comparator if the latch signal is output from the second comparator and a voltage of the latch signal transmitted to the second input terminal of the second comparator by the first diode is higher than the second reference voltage.

7. The switch control device as claimed in claim 6, wherein the latch circuit further includes a second voltage divider circuit connected between a power node and the ground and configured to apply the second reference voltage divided from a voltage applied to the power node to the first input terminal of the second comparator.

8. The switch control device as claimed in claim 6 or claim 7, wherein the latch circuit further includes a second diode including an anode connected to the output terminal of the second comparator and a cathode connected to the off circuit.

9. The switch control device as claimed in any preceding claim, wherein:
the off circuit includes a transistor including a first terminal connected to a switch driver that controls the switch, a second terminal connected to the ground, and a control terminal, and
the transistor is turned on if the overcurrent detection signal or the latch signal is inputted to the control terminal, and if turned on, the switch driver and the ground are connected to output the off signal corresponding to a ground voltage to the switch driver.

10. The switch control device as claimed in claim 9, wherein the off circuit further includes a delay circuit that is configured to:
receive the overcurrent detection signal or the latch signal;
delay the received overcurrent detection signal or latch signal; and
transmit the delayed signal to the control terminal of the transistor.

11. The switch control device as claimed in claim 10, wherein the delay circuit includes:
a second resistor connected between a node connected to the overcurrent detection circuit and the latch circuit to receive the overcurrent detection signal or the latch signal and the control terminal of the transistor, and
a second capacitor connected between the control terminal of the transistor and the ground.

12. A battery pack, comprising:
a battery module;
a switch in a current path between the battery module and a load;
a switch driver configured to control an on/off status of the switch; and
the switch control device as claimed in any preceding claim,
wherein the switch control device is configured to, if an overcurrent is detected in the current path, output the off signal turning off the switch to the switch driver.

13. The battery pack as claimed in claim 12, further comprising a controller configured to control the switch driver independently of the switch control device.
